(19) Europäisches Patentamt
European Patent Office
Office européen des brevets

(11) **EP 1 651 018 A1**

(12) **EUROPEAN PATENT APPLICATION**
published in accordance with Art. 158(3) EPC

(43) Date of publication:
**26.04.2006 Bulletin 2006/17**

(51) Int Cl.:
**H05K 3/10** (1968.09)     **G09F 9/30** (1968.09)

(21) Application number: **04735653.0**

(22) Date of filing: **01.06.2004**

(86) International application number:
**PCT/JP2004/007880**

(87) International publication number:
**WO 2004/110117 (16.12.2004 Gazette 2004/51)**

(84) Designated Contracting States:
**DE FR GB**

(30) Priority: **04.06.2003 JP 2003159315**

(71) Applicants:
• **OHMI, Tadahiro**
  **Sendai-shi,**
  **Miyagi 980-0813 (JP)**
• **ZEON CORPORATION**
  **Chiyoda-ku**
  **Tokyo 100-8323 (JP)**

(72) Inventors:
• **OHMI, Tadahiro**
  **Sendai-shi, Miyagi 9800813 (JP)**

• **MORIMOTO, Akihiro**
  **Sendai-shi, Miyagi 989-3128 (JP)**
• **SUZUKI, Teruhiko,**
  **c/o Zeon Corporation**
  **Chiyoa-ku, Tokyo 100-8246 (JP)**
• **KATO, Takeyoshi,**
  **c/o Zeon Corporation**
  **Chiyoda-ku, Tokyo 100-8246 (JP)**

(74) Representative: **Vossius & Partner**
  **Siebertstrasse 4**
  **81675 München (DE)**

(54) **SUBSTRATE AND PROCESS FOR PRODUCING THE SAME**

(57)     A photosensitive transparent resin film, provided selectively with a groove reaching a transparent substrate is formed on the transparent substrate, and a wiring portion is provided in the groove substantially in flush with the photosensitive transparent resin film. The wiring portion can be formed quickly while controlling the thickness easily by preprocessing the surface of the photosensitive transparent resin film or the bottom face of the groove before the wiring portion is set in the groove.

FIG. 1

**Description**

Technical Field

This invention relates to a substrate and a manufacturing method thereof and, in particular, relates to a wiring substrate for use in a display device or the like and a manufacturing method thereof.

Background Art

Generally, a display device such as a liquid crystal display device, an organic EL device, or an inorganic EL device is fabricated by forming films and patterning the films into conductive patterns such as a wiring pattern and an electrode pattern in order on a transparent substrate or the like having a flat main surface. Specifically, a wiring pattern is formed on the main surface of the transparent substrate by adhering a conductive film to be formed as wiring necessary for the display device and selectively etching the conductive film using a photolithography technique or the like. Then, likewise, an electrode film and various films necessary for elements that constitute the display device are formed and patterned, so that the display device is manufactured.

In recent years, there is a strong demand for an increase in size with respect to the display device of this type. In order to form a large-size display device, it is necessary to form more display elements on a transparent substrate with high accuracy and electrically connect these elements to a wiring pattern. In this case, insulating films, TFT elements, light emitting elements, and so on are formed, in addition to the wiring pattern, on the transparent substrate in a multilayer structure. As a result, level differences are normally formed on the transparent substrate in a stepwise fashion and the wiring pattern is wired over these level differences.

Further, upon increasing the size of the display device, since the wiring pattern itself becomes longer, it is necessary to reduce the resistance of the wiring pattern. As a technique of reducing the resistance of the wiring pattern, Japanese Unexamined Patent Application Publication (JP-A) No. H4-170519 (hereinafter referred to as patent document 1) discloses a technique wherein, in order to form wiring for a flat panel display such as a liquid crystal display, a groove is formed on the surface of a transparent substrate such as a glass substrate and a wiring pattern is provided in the groove. Further, patent document 1 discloses that a wiring pattern is formed on the surface of a transparent substrate and a transparent insulating material is formed in contact with the wiring pattern so that the insulating material has substantially the same height as the wiring pattern.

On the other hand, Japanese Unexamined Patent Application Publication (JP-A) No. H10-209463 (hereinafter referred to as patent document 2) discloses a wiring forming method wherein, in order to reduce the resistance of wiring and improve brightness (aperture ratio) of a display screen, a first wiring pattern is provided by selectively forming a transparent conductor film such as an ITO film on the surface of a display substrate and, after covering the first wiring pattern and the surface of the display substrate with a resist film having transparency, the resist film is selectively opened to expose a part of the first wiring pattern and a second wiring pattern having a greater thickness and a narrower width than the first wiring pattern is formed on the exposed first wiring pattern by electroless plating.

In this manner, by using the transparent conductive film having the relatively wide width as the first wiring pattern, what shields light in the thickness direction becomes only the second wiring pattern to thereby enable a reduction of a shield area in the thickness direction and, further, by forming the second wiring pattern having the large thickness, the resistance of the whole wiring patterns can be reduced.

In patent document 1, in order to form the groove on the glass substrate itself and leave the wiring only in the groove, after deposition or application of a wiring material over the whole surface of the transparent substrate in which a groove is formed, the surface of the wiring material is polished to thereby expose the surface, other than the groove, of the transparent substrate. Similarly, the wiring material is also polished in order to cause the wiring pattern to have the same height as the insulating material on the transparent substrate. However, a high-level technique is required for exposing the wiring pattern only at the predetermined portion by polishing as described above and, in particular, when the wiring increases like in a large-area display device, it becomes difficult to carry out uniform polishing.

On the other hand, in patent document 2, the resist film having transparency is formed on the substrate having the first wiring pattern and, by developing, exposing, and removing the resist film, an opening portion is formed in the resist film in the form of a tapered groove on the first wiring pattern. Then, the second wiring pattern is formed on the inner side of the first wiring pattern by electroless plating. This method is not practical because the formation of the first and second wiring patterns increases the manufacturing processes to thereby require much time and cost. Further, there is a problem that rising of the surface of the resist film covering the first wiring pattern degrades the flatness of the resist film. As a result, a level difference is generated on the surface of the resist film.

As described above, when another electrode pattern is formed on the resist surface having the level difference and on the second wiring pattern and the wiring and the electrode pattern are electrically connected, there is a drawback that the electrode pattern or the like are often subjected to an accident such as disconnection or short and therefore the yield is low in the display device manufacture.

It is an object of this invention to provide a substrate that can reduce occurrence of disconnection, short, or the like by optimizing a relationship between a thickness and a width of a wiring pattern to thereby cause the surface of the wiring pattern and the surface of a transparent substrate to be substantially flush with each other.

It is another object of this invention to provide a simple method of manufacturing, without using a polishing process, a substrate with wiring having a flat surface over the wide area.

It is another object of this invention to provide a substrate that can reduce occurrence of disconnection, short, or the like in later processes or the like.

It is another object of this invention to provide a substrate that easily enables electrical connection or the like using a transparent photosensitive resin composition.

It is another object of this invention to provide a substrate that can reduce occurrence of disconnection, short, or the like at the time of electrical wiring or the like.

Disclosure of the Invention

According to this invention, there is obtained a transparent substrate having a structure comprising a transparent film provided on a transparent base and having a groove formed so as to expose the surface of the transparent base, and a wiring pattern filled in the groove by screen printing or the like so that the wiring pattern is integrated. In this case, the wiring portion in the groove has a width and thickness determined by correlation with a maximum width and minimum width of the groove so that the surface of the transparent substrate and the surface of the wiring pattern can be substantially flat with each other. Therefore, when a power supply pattern for a display element or the like is formed on the surface of the transparent substrate, a contact with the wiring pattern buried in the transparent substrate can be suitably carried out. This is because, since there is no substantial level difference between the wiring pattern and the transparent substrate to ensure high flatness, an electrode pattern or the like can be directly formed on the wiring pattern so that disconnection or the like caused by a level difference can be prevented.

The transparent substrate buried with the wiring pattern can be manufactured by forming a transparent film on a transparent base, forming a groove in the transparent film so as to expose the main surface of the transparent base, and burying a conductive film in the groove by screen printing or the like. In this case, since a polishing process or the like is not required, the wiring pattern can be easily formed over the wide area at a low cost.

As the wiring filled and buried in the groove, it is suitable to use an opaque low-resistance material, for example, a metal such as copper or aluminum upon constituting a large-size display device. On the other hand, in the case of a small-size display device, it is also possible to use a relatively high-resistance transparent conductive material such as ITO.

By applying a pretreatment to the surface of the transparent film before burying the wiring pattern, it is possible to cause the material of the wiring pattern to adhere only to the groove and the exposed surface of the transparent base.

Herein, description will be made about a material of the transparent base, the transparent film, a material used in the pretreatment, and a material of the wiring portion, which constitute this invention

At first, the wiring buried type transparent substrate according to this invention is applicable to a flat display panel such as not only a liquid crystal display device but also an organic EL device, an inorganic EL device, or the like. In consideration of this, in this invention, use can be made, as the transparent base, of a glass plate of quartz glass, no-alkali glass, or the like, a plate-like or film-like plastic plate, or the like. In this case, use can also be made, as the glass plate, of a plate of one of various glasses such as soda-lime glass, barium-strontium-containing glass, lead glass, and borosilicate glass. As the plate-like or film-like plastic plate, use can be made of polymer having an alicyclic structure, polycarbonate, acrylic resin, polyethylene terephthalate, polyether sulfide, polysulfone, or the like. As the polymer having an alicyclic structure, although there are, for example, a cycloalkane structure and a cycloalkene structure, the cycloalkane structure is preferable in view of thermal stability. Although there is no particular limitation to the number of carbons forming the alicyclic structure, it is normally 4 to 30, preferably 5 to 20, and more preferably 6 to 15. Specifically, among the polymers having an alicyclic structure, norbornene-based polymers are preferable in view of transparency and formability and, among the norbornene-based polymers, a hydrogenated ring-opened polymer of norbornene-based monomers is most preferable in view of heat resistance and transparency.

When the plastic plate is used as the transparent base, a physical or chemical surface treatment may be applied thereto in order to improve adhesion with respect to a photosensitive transparent resin film to be formed thereon.

The transparent film formed on the transparent base can be made of, for example, a silica-based inorganic material or organic material. As the organic material of the transparent film, use can be made of a transparent resin selected from the group consisting of an acrylic-based resin, a silicone-based resin, a fluorine-based resin, a polyimide-based resin, a polyolefin-based resin, an alicyclic olefin-based resin, and an epoxy-based resin.

Among these transparent resins, the photosensitive transparent resin film is suitable in terms of facilitating subsequent processes. Particularly, as the photosensitive transparent resin film, it is preferable to use a photosensitive resin composition as described in detail in Japanese Unexamined Patent Application Publication (JP-A) No. 2001-188343 or Japanese Unexamined Patent Application Publication (JP-A) No. 2002-296780. In this case, the resin composition forming the photosensitive transparent resin flm is a composition containing an alkali-soluble alicyclic olefin polymer obtained by denaturation reaction of a compound having an acid derivative residue such as an amide group or a carboxyl group with an alicyclic olefin polymer, a crosslinking agent such as alkoxymethylated melamine or alkoxymethylated glycol uryl, and a photoacid generator such as a halogen-containing triazine compound, or a composition obtained by adding a dissolution control agent to the foregoing composition. The photosensitive transparent resin film used in this invention may be positive or negative.

As the wiring portion buried in the groove formed in the photosensitive transparent resin film, use can be made of Ni, Cr, Cu, Al, W, Mo, Ta, Au, In, Ti, Ag, an alloy of them, or the like. The wiring portion in the groove may have a single-layer structure of the foregoing material or a structure in which one or more of the foregoing materials are stacked in layers.

As a method of forming the wiring portion, it is preferable to use a printing method such as a screen printing method in view of productivity and pattern selection. However, a lift-off method or a plating method may also be used. Further, it is also possible to form the wiring portion by a sputtering method or the like.

Brief Description of the Drawings

Fig. 1, (a), (b), (c), (d), (e), and (f) are diagrams showing fabrication processes of a transparent substrate according to this invention in order of process.
Fig. 2 is a sectional view for explaining one example of a wiring buried type substrate according to this invention.
Fig. 3 is a sectional view showing another example of a wiring buried type substrate according to this invention.
Fig. 4 is a sectional view for explaining a pretreatment according to this invention.
Fig. 5 is a plan view for explaining a display element in the case where a liquid crystal display device is constituted by the use of the wiring buried type substrate of this invention.
Fig. 6 is a sectional view taken along line X-X' in Fig. 5.
Fig. 7 is a plan view for explaining a conventional display element.

Best Mode for Carrying Out the Invention

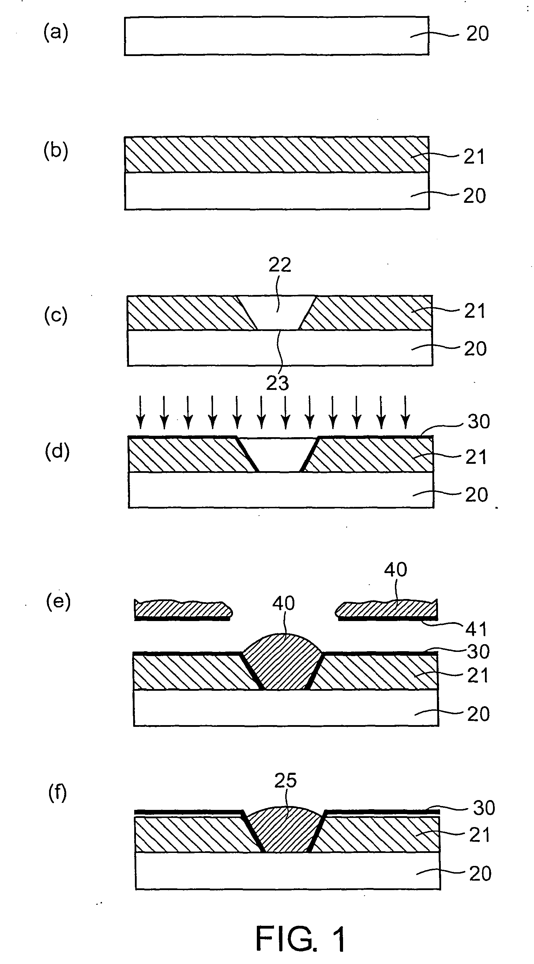

At first, the principle of this invention will be described with reference to Fig. 1.
On a main surface of a transparent glass substrate 20 in Fig. 1, (a), a transparent resin film having photosensitivity (hereinafter, the photosensitive transparent resin film) 21 with a thickness of 10nm to 10$\mu$m (preferably in the range of 100nm to 5$\mu$m) is formed by a spin-coat technique or the like (Fig. 1, (b)). This photosensitive transparent resin film 21 has a function as a photoresist film.
Then, by selectively exposing, developing, and removing the photosensitive transparent resin film 21 using activated radiation, a groove 22 is formed in the photosensitive transparent resin film 21, as shown in Fig. 1 (c). As shown in the figure, the groove 22 has a tapered sectional shape and reaches the surface of the transparent base 20 from the surface of the photosensitive transparent resin film 21, thereby exposing a transparent base surface 23. In this example, the tapered groove 22 has a maximum width W1 at the surface of the photosensitive transparent resin film 21 and a minimum width W2 at the bottom on the transparent base 20 side. As the activated radiation in this case, use can be made of ultraviolet radiation, KrF excimer laser light, ArF excimer laser light, X-radiation, electron beam, or the like. Although the single groove 22 is shown in the figure, a number of grooves are actually formed.
Herein, at the bottom of the tapered groove 22 formed in the photosensitive transparent resin film 21, no conductor pattern or the like that causes a level difference at the surface of the photosensitive transparent resin film 21 is provided.
Next, as shown in Fig. 1 (d), a NF$_3$ gas is supplied to the substrate in a plasma processing apparatus and this gas is activated by a plasma to thereby treat the transparent resin surface so that a water-repellent wiring formation assistant layer 30 made of a fluorocarbon is provided on the surface (also including the side wall surfaces in the groove 22) of the transparent resin 21 containing carbon. In this event, the exposed surface 23 of the glass substrate 20 maintains hydrophilicity.
Successively, as shown in Fig. 1 (e), a conductive ink 40 is selectively applied to the inside of the groove 22 by screen printing using a screen 41. The ink 40 is obtained by dispersing copper powder into a solvent. The ink 40 is repelled and does not get on the water-repellent assistant layer 30 and is thus filled into the groove 22 with higher accuracy than that of the mask 41. Since the bottom surface of the groove 22 is hydrophilic, the ink 40 efficiently adheres to and stays in the groove 22.
Subsequently, as shown in Fig. 1 (f), the solvent of the ink 40 is vaporized by baking, thereby obtaining a wiring portion 25.
In this manner, the wiring portion 25 is formed by the conductor in the tapered groove 22. As a method of forming the wiring portion 25, use can be made of a plating method, a sputtering method, or the like other than the foregoing printing method. In any event, the wiring portion 25 is provided on the transparent base 20 and has a thickness so as to form a surface that is substantially flush with the surface of the photosensitive transparent resin film 21. As shown in the figure, it is to be noted that any conductor film having a thickness that causes a level difference at the surface of the photosensitive transparent resin film 21 does not lie between the transparent base 20 exposed at the bottom of the groove 22 and the wiring portion 25.

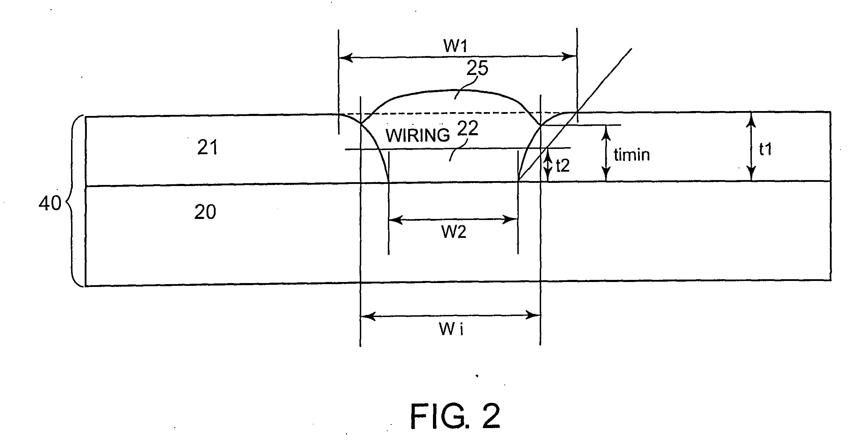

Referring to Fig. 2, description will be made about a condition for setting the thickness of the wiring portion 25 so that the wiring portion 25 is substantially flush with the photosensitive transparent resin film 21.

The shown groove 22 has the maximum width W1 on the surface side of the photosensitive transparent resin film 21 and the minimum width W2 at the bottom on the transparent base 20 side. In this case, the average width of the groove 22 can be represented by (W1+W2)/2. In Fig. 2, the same reference numerals are assigned to the same portions as those in Fig. 1.

On the other hand, it is assumed that the thickness of the photosensitive transparent resin film 21 is represented as t1, the thickness of the photosensitive transparent resin film 21 at the average width position of the groove 22 is represented as t2, and, as shown in Fig. 1, the wiring portion 25 has a convex shape. In this case, it is understood that the distance between two points where the groove 22 and the wiring portion 25 contact each other defines a maximum wiring width of the wiring portion 25 and the wiring portion 25 has a minimum thickness at the position of this maximum wiring width. Herein, it is assumed that the maximum wiring width of the wiring portion 25 is represented as Wi and the minimum thickness of the wiring portion 25 is represented as timin.

In this invention, the wiring portion 25 having the maximum wiring width Wi is formed so that the maximum wiring width Wi of the wiring portion 25 satisfies, with respect to the maximum width W1 and minimum width W2 of the groove 22, a relationship of W2≤Wi≤W1. On the other hand, the wiring portion 25 is formed so that the minimum thickness timin falls within the range represented by the following formula.

$$t2 \leq timin \leq t1$$

When the minimum thickness timin of the wiring portion 25 is set to a thickness within the range defined by the above formula, the maximum thickness of the wiring portion 25 is mainly determined by a surface tension of a material forming the wiring portion 25. Therefore, the thickness of the wiring portion 25 can be substantially the same as that of the photosensitive transparent resin film 21. As a result, the surface of the wiring portion 25 can be substantially flush with the surface of the photosensitive transparent resin film 21. In other words, it has been found out that when the maximum width Wi and minimum thickness timin of the wiring portion 25 are set in the foregoing ranges, even if other wiring layers or the like are formed on the wiring portion 25, those other wiring layers are not subjected to disconnection or the like.

In the example of Fig. 2, the description has been made about the groove 22 having the maximum width at the surface of the photosensitive transparent resin film 21 and the minimum width at the bottom surface of the photosensitive transparent resin film 21. It has been confirmed that this also applies to an inversely tapered groove having, conversely, the minimum width at the surface of the photosensitive transparent resin film 21 and the maximum width at the bottom surface of the photosensitive transparent resin film 21.

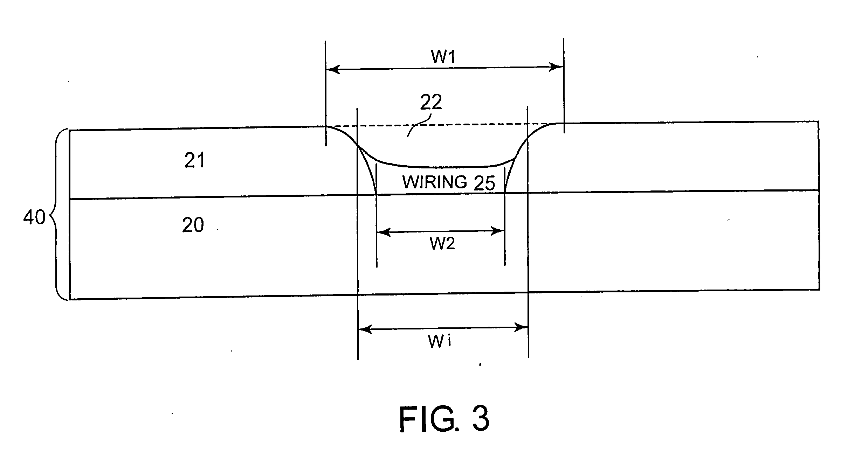

On the other hand, it has been confirmed that even in the case where, as shown in Fig. 3, a concave portion is formed in relation to a material of a wiring portion 25 due to scattering or the like of a binder or the like contained in the material of the wiring portion 25 conversely to Fig. 2, as long as a maximum width Wi of the wiring portion 25 satisfies the foregoing formulas, even if upper layers such as other wiring, electrodes, and an insulating layer are disposed on the wiring portion 25, those upper layers are not subjected to occurrence of disconnection due to a level difference. In this case, the distance between two points where the wiring portion 25 contacts with the groove 22 is the maximum width Wi and the thickness at the maximum width position defines a maximum thickness of the wiring portion 25. It has been experimentally confirmed that even if this maximum thickness is reduced by about a thickness determined by the influence of the binder or the like in the material forming the wiring portion 25, the other wiring etc. on the wiring portion 25 are not subjected to occurrence of disconnection or the like. It is noted here that the width Wi of the wiring portion 25 in the groove 22 is required to be greater than an average width ((W1+W2)/2) of the groove 22.

Herein, it is assumed in Fig. 2 that, in the photosensitive transparent resin film 21 having a thickness of 2$\mu$m, the groove 22 of which the maximum width W1 and minimum width W2 are 2.15 and 1.85$\mu$m is formed, respectively. In this case, it is required that the minimum thickness (timin) of the wiring portion 25 at the position of the maximum width Wi is greater than the thickness (t2) of the photosensitive transparent resin film 21 at the position of the average width (2$\mu$m) of the groove 22 and smaller than the thickness (t1=2$\mu$m) of the photosensitive transparent resin film 21.

The method of quickly and simply forming the wiring portion 25 has been described with reference to Fig. 1. Herein, description will be made about a more general forming method. At first, an electroless plating method can be used as the method of forming the wiring portion 25 although there is a problem in view of time and cost. Also in this case, it is preferable to use a technique of applying a pretreatment to the surface of the photosensitive transparent resin film 21 formed with the groove 22 and/or the surface of the transparent base 20 to thereby facilitate formation of the wiring portion 25 in the groove 22.

Herein, description will be made about a case where a wiring formation assistant layer for assisting wiring formation is formed on the surface of the photosensitive transparent resin film 21. As this wiring formation assistant layer, a water-repellent layer, an oil-repellent layer, or the like, for example, is formed depending on a method of forming the wiring portion 25.

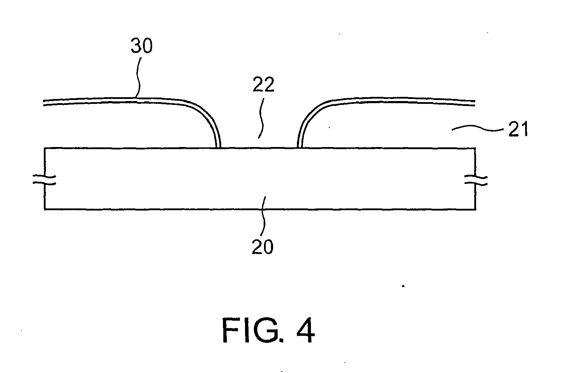

In case where the wiring portion 25 is formed by the plating method, a water-repellent layer is formed as the wiring formation assistant layer 30 on the surface of the photosensitive transparent resin film 21 as shown in Fig. 4. This water-repellent layer may be formed, for example, by applying a fluorine-based water-repellent treatment activated by plasma processing described with reference to Fig. 1 or the like, or by activating a water repellent contained in the photosensitive transparent resin film 21. By forming the water-repellent layer as illustrated, the wiring portion 25 can be formed only in the groove 22 by plating so that a process after the formation of the wiring portion 25 can be simplified.

In case where the wiring portion 25 is formed by the sputtering method, use may be made of a technique of forming a lift-off layer as the wiring formation assistant layer 30 only on the surface of the photosensitive transparent resin film 21 and then stripping the lift-off layer after forming a film of a wiring layer material by sputtering.

On the other hand, as shown in Fig. 1, the wiring portion 25 can be formed by the printing method such as the screen printing method. By forming as the wiring formation assistant layer 30 a layer of a material having ink repellency against a wiring ink used in the printing method, since the ink does not adhere to the wiring formation assistant layer 30, the wiring portion 25 can be easily formed only in the groove 22.

As the photosensitive transparent resin film 21, use can be made of either a positive photoresist whose exposed portion generates a photochemical reaction so as to be soluble in a developer or a negative photoresist whose exposed portion becomes insoluble in a developer. As the wiring formation assistant layer 30, a layer of a material having inkphilicity may be formed.

In the foregoing example, the description has been made about the case where the wiring formation assistant layer 30 is formed on the surface of the photosensitive transparent resin film 21 formed on the transparent base 20. However, the wiring formation assistant layer 30 may be formed on the surface of the transparent base 20.

Specifically, an insulating catalyst film in the form of a monomolecular layer or several-molecular layer containing palladium or the like is formed as a wiring formation assistant layer on the surface of the transparent base 20, then the photosensitive transparent resin film 21 is formed on the catalyst film, then the groove 22 is provided by selectively removing the photosensitive transparent resin film 21 to expose the catalyst film, and then the substrate is immersed in an electroless plating solution or the like, thereby forming the wiring portion 25.

Further, a wiring formation assistant film made of a material having hydrophilicity or inkphilicity may be formed at the bottom of the groove 22 and, in the state where this wiring formation assistant film is provided, the wiring portion 25 may be formed. The hydrophilic or inkphilic wiring formation assistant film may be formed not only at the bottom of the groove 22 but also on the side surfaces of the groove 22. In this case, a wiring formation assistant film made of a water-repellent or ink-repellent material may be formed on the surface of the photosensitive transparent resin film 21 excluding the groove 22.

By providing the wiring formation assistant film on the photosensitive transparent resin film 21 or the transparent base 20, the subsequent formation of the wiring portion 25 can be carried out in a short time and at a low price. For example, by immersing the substrate in a conductive ink liquid or applying a conductive ink to only the groove portion or the whole surface of the substrate by injection, spraying, jet, or the like in the state where the surface of the photosensitive transparent resin film 21 is covered with the ink-repellent wiring formation assistant film 30 as shown in Fig. 4, the ink adheres only in the groove 22 so that the wiring portion 25 can be formed quite easily. In this case, since the wiring portion 25 is formed only in the groove 22, the ink removal operation or the like becomes substantially unnecessary thereafter so that the formation of the wiring portion 25 can be performed quickly. When such a method or the other printing technique is used, the wiring portions 25 can be uniformly formed over the wide area. Therefore, it is possible to easily fabricate a wiring buried type substrate 40 for a large-screen liquid crystal display device.

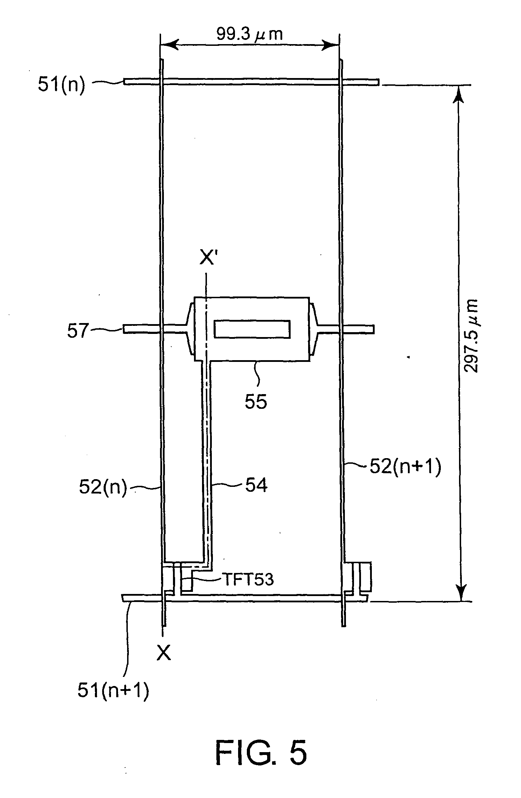

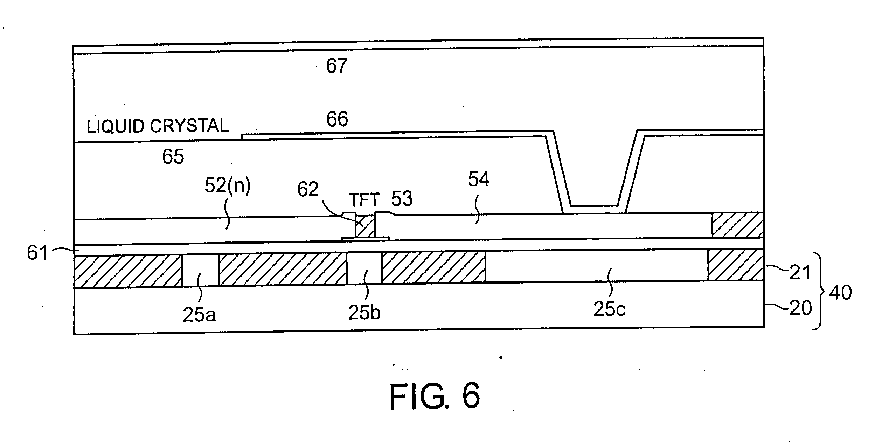

Referring to Figs. 5 and 6, an example in which the foregoing wiring buried type substrate is applied to a substrate on the TFT (Thin Film Transistor) side of a 30-inch QXGA (2048x1516 pixels) liquid crystal display device is shown.

In a plan view of Fig. 5, a display element for one pixel of the liquid crystal display device is shown. The shown display element has gate wirings 51(n) and 51(n+1) arranged in parallel in a lateral direction and source wirings 52(n) and 52(n+1) formed in a longitudinal direction and further has a TFT 53. The TFT 53 has a gate electrode connected to the gate wiring 51(n+1) and a source electrode connected to the source wiring 52(n), and a drain electrode thereof is connected to an auxiliary capacitance 55 while the auxiliary capacitance 55 is electrically coupled to an auxiliary capacitance line and a leader line 57 thereof.

Referring also to Fig. 6, a sectional view taken along X-X' line in Fig. 5 is shown. The display element is formed using the wiring buried type substrate shown in Fig. 2 or 3.

As shown in Fig. 6, a photosensitive transparent resin film 21 is formed on a transparent base 20 and the photosensitive transparent resin film 21 is provided with wiring portions 25 that are formed so as to be substantially flush with the surface of the photosensitive transparent resin film 21 (in Fig. 6, taper of each groove is omitted for simplifying description).

As apparent from Figs. 5 and 6, the wiring portions 25 buried in the photosensitive transparent resin film 21 are formed by gate wirings 25a and 25b and an auxiliary capacitance line 25c. These buried wirings 25a, 25b, and 25c are formed according to the technique described before. As a result, the shown wiring buried type substrate 40 forms a substantially flat main surface. The auxiliary capacitance line 25c is connected to the auxiliary capacitance leader line 57 shown in Fig. 5.

On the surface of the wiring buried type substrate 40 having the substantially flat main surface, an insulating film 61 serving as a gate insulating film in a region of the TFT 53 is formed on the gate wiring 25b. Further, on this gate insulating film, a semiconductor region 62 made of amorphous silicon or the like is provided. The source wiring 52(n) and a drain wiring 54 are provided in the semiconductor region 62 so that the TFT 53 is formed.

In the shown example, a protective insulating film 65 is formed so as to cover the source wiring 52(n) and the TFT 53. A pixel electrode 66 made of ITO or the like is formed on the protective instating film 65 so as to be electrically connected to the drain wiring 54. A common electrode 67 is disposed over the pixel electrode 66 and the protective insulating film 65 with a spacing therebetween. Liquid crystals are placed between the common electrode 67 and the pixel electrode 66 so that a liquid crystal cell is constituted by the pixel electrode 66, the common electrode 67, and the liquid crystals.

Herein, description will be made about dimensions of the wiring portions 25 of the wiring buried type substrate 40 shown in Figs. 5 and 6. In Fig. 5, the width of each of the gate wirings 51(n) and 51(n+1) is 3μm and the width of each of the source wirings 52(n) and 52(n+1) is 2μm. Further, the auxiliary capacitance leader line 57 serving as a leader line of the auxiliary capacitance line 25c has a width of 3μm. On the other hand, the thickness of each of the wiring portions 25a and 25b forming the gate wirings 51(n) and 52(n+1) is 2μm.

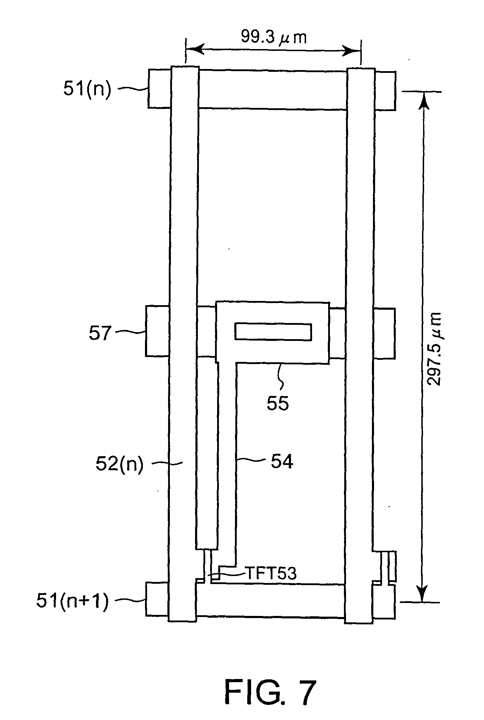

Herein, a display element for one pixel of a conventional liquid crystal display device will be described with reference to Fig. 7 for comparing the dimensions of the display element according to this invention shown in Fig. 5.

The display element shown in Fig. 7 comprises, like in Fig. 5, gate wirings 51(n) and 51(n+1), source wirings 52(n) and 52(n+1), a TFT 53, a drain wiring 54, an auxiliary capacitance 55, and an auxiliary capacitance leader line 57.

Assuming that the display element shown in Fig. 7 has a pixel size of 297.5μm long and 99.3μm broad like the display element shown in Fig. 5, the gate wirings 51(n) and 51(n+1) each require a width of 20μm in the display element shown in Fig. 7. Likewise, in the display element of Fig. 7, the source wirings 52(n) and 52(n+1) each require a width of 15μm and the auxiliary capacitance leader line 57 requires a width of 30μm. This is because the source wirings 52 cross the gate wirings 51 and the auxiliary capacitance leader line 57 with a level difference on the substrate.

As described above, when the display element having the same size as conventional is formed using the wiring buried type substrate according to this invention, the width of each of the gate wirings 51 and the source wirings 52 can be reduced to about 1/7 and the width of the auxiliary capacitance leader line 57 can be reduced to 1/10. This means that, in this invention, the thickness of each of the gate wirings 51, the source wirings 52, and the auxiliary capacitance leader line 57 can be increased as compared with the conventional display element so that the aperture ratio of the display element can be largely improved. In other words, when the substrate according to this invention is used, the display element can be further miniaturized so that a highly accurate display panel can be constituted.

In this manner, when the wiring buried type substrate according to this invention is used, since the surface of the substrate is flat, even when the widths of the source wirings and so on disposed on the surface of the substrate are narrowed, an accident such as disconnection or short, or the like does not occur. As a result, in case where a liquid crystal display device is constituted using the wiring buried type substrate of this invention, it is possible to obtain the display device having an extremely high aperture ratio.

In the foregoing embodiment, only the liquid crystal display device has been described. However, this invention is applicable to various substrates that constitute flat display panels.

Further, as a material forming the wiring portion 25, not only an opaque metal such as copper, aluminum, or tungsten is used, but also, for example, a transparent conductive film such as ITO may be formed at the wiring portion 25.

(Example)

Herein, an example of a wiring buried type substrate according to this invention will be described with reference to Fig. 1. At first, a glass base is prepared as a transparent base 20. As this glass base, use can be made of a glass base having a size that can form a 30-inch large-size screen. After performing ultrasonic cleaning of the glass base for 5 minutes using isopropyl alcohol, the glass base was rinsed with pure water for another 5 minutes to thereby remove the isopropyl alcohol. Thereafter, the glass base was dried in a nitrogen atmosphere at 130°C for 30 minutes or more.

After hexamethyldisilazane-steaming of the dried glass base, a positive photoresist liquid was applied to the surface thereof using a spinner. Then, the glass base with the photoresist liquid was subjected to a prebaking process of heating at 100°C for 120 seconds on a hot plate, thereby forming a photosensitive transparent resin film 21 having a thickness of 1500nm. As the foregoing positive photoresist, use was made of a photoresist containing an alkali-soluble alicyclic olefin-based resin described in Japanese Unexamined Patent Application Publication (JP-A) No. 2002-296780.

Then, mixed light of g, h, and i was selectively irradiated onto the photosensitive transparent resin film 21 through a mask pattern using a mask aligner. Then, after performing development for 90 seconds using a 0.3wt% tetramethylammonium hydroxide aqueous solution, a rinsing process was carried out for 60 seconds using pure water. In this manner, grooves 22 having a predetermined pattern were formed on the glass base 20. Thereafter, a heat treatment was carried out in a nitrogen atmosphere at 230°C for 60 minutes to thereby cure the photosensitive transparent resin film.

Subsequently, the glass base with the photosensitive transparent resin film in which the grooves 22 were formed was subjected to $NF_3$ plasma processing. In this manner, a water-repellent layer 30 was formed on the photosensitive transparent resin film. Then, a low-resistivity ink containing Cu was used as a wiring material and selectively filled in the grooves 22 by screen printing. Thereafter, the ink solvent was vaporized by a heat treatment at 280°C for 60 minutes in a nitrogen atmosphere mixed with 1vol% of hydrogen, thereby forming opaque wiring portions 25. In this case, the wiring portions 25 were filled in the grooves 22 so as to provide substantially no level difference with respect to the surface of the photosensitive transparent resin film 21 thus to be flush therewith. Thereby, a wiring buried type substrate 40 having the thick wiring portions 25 was obtained.

Industrial Applicability

According to this invention, in a photosensitive transparent resin film provided on a transparent base, grooves each reaching the transparent base are selectively formed. A wiring portion is buried in each groove so that it is possible to form the wiring portions each having a greater thickness than conventional.

Further, since the width of the wiring portion can be reduced by increasing the thickness of the wiring, an opening portion can be enlarged in the case of a display element.

Further, as a wiring substrate, the parasitic capacitance of wiring can be reduced so that it is possible to increase the signal speed during operation and reduce the power consumption.

Further, by applying a pretreatment, such as formation of a wiring formation assistant film, to the surface of the photosensitive transparent resin film or the transparent base, the formation of the wiring portion can be limited only to the groove. Therefore, the wiring portion can be formed easily and quickly.

**Claims**

1. A substrate, comprising:

a transparent base,
a transparent film in which a groove is formed to reach a main surface of said transparent base, and
a wiring portion formed in said groove,
wherein said groove has a maximum width and a minimum width ,and said wiring portion in said groove has a width and a thickness determined by correlation with the maximum width and the minimum width of said groove.

2. The substrate according to claim 1, wherein:

said transparent film is made of a transparent resin.

3. The substrate according to claim 1, wherein:

said transparent film is made of a photosensitive transparent resin.

4. The substrate according to claim 1, wherein:

said wiring portion is transparent or opaque.

5. The substrate according to claim 1, wherein:

said transparent film contains inorganic matter.

6. The substrate according to claim 1, wherein:

said transparent film is formed using a resin composition comprising an alkali-soluble alicyclic olefin resin and a radiation-sensitive component.

7. The substrate according to claim 1, wherein:

a surface of said transparent film and a surface of said wiring portion are substantially flush with each other.

8. The substrate according to claim 1, wherein:

when the maximum width and the minimum width of said groove in transverse section are represented as W1 and W2, respectively, a maximum wiring width Wi of said wiring portion in said groove has a relationship of $W2 \leq Wi \leq W1$.

9. The substrate according to claim 8, wherein:

when a thickness of said wiring portion in said groove at the maximum wiring width Wi is represented as ti, a thickness of said transparent film is represented as t1, and a thickness of said transparent film at a position of an average width ((W1+W2)/2) of said groove is represented as t2, the thickness ti at a position of said maximum wiring width falls within the range of t2≤ti≤t1.

10. The substrate according to claim 1, wherein:

said transparent base is made of a glass or a plastic material.

11. A display device manufactured using said substrate according to claim 1.

12. The display device according to claim 11, wherein:

said display device is a liquid crystal display device or an EL display device.

13. A substrate manufacturing method, comprising the steps of:

forming a transparent resin film on a surface of a transparent base, selectively removing a surface of said transparent resin film to thereby form a groove reaching said transparent base, and forming a wiring portion in said groove, said wiring portion reaching the surface of said transparent base, wherein, in the step of forming said wiring portion, said wiring portion is formed so that a surface of said wiring portion and the surface of said transparent resin film become substantially flush with each other, thereby obtaining a substrate buried with said wiring portion.

14. The substrate manufacturing method according to claim 13, further comprising:

a pretreatment step of treating the surface of said transparent resin film before the step of forming said wiring portion, wherein, in said pretreatment step, a wiring formation assistant layer is formed on the surface of said transparent resin film to prevent forming a material of said wiring portion on said wiring formation assistant layer, thereby assisting the formation of the material of said wiring portion in said groove.

15. The substrate manufacturing method according to claim 14, wherein:

said pretreatment step includes the formation of said wiring formation assistant layer on the surface of said transparent resin film, and said wiring formation assistant layer is selected in relation to the step of forming said wiring portion.

16. The substrate manufacturing method according to claim 13, further comprising:

a pretreatment step of forming, on a bottom surface of said groove, a wiring formation assistant layer that serves to assist adhesion of a material of said wiring portion on the surface of said transparent base.

17. The substrate manufacturing method according to claim 13, wherein:

said transparent resin film is made of a photosensitive resin composition ,and said photosensitive resin composition comprises a resin selected from the group consisting of an acrylic-based resin, a silicone-based resin, a fluorine-based resin, a polyimide-based resin, a polyolefin-based resin, an alicyclic olefin-based resin, and an epoxy-based resin.

18. A substrate manufacturing method, comprising the steps of:

selectively providing a wiring formation assistant layer, which serves as a sacrifice layer, on a surface of a transparent base, forming a transparent resin film on an exposed surface of said transparent base and said wiring formation assistant layer, forming a groove in said transparent resin film, and forming a wiring portion in said groove, wherein, in the step of forming said wiring portion, said wiring portion is formed so that a surface of said wiring portion and a surface of said photosensitive transparent resin film become substantially flush with each other, thereby obtaining a substrate buried with said wiring portion.

19. The substrate manufacturing method according to claim 13, wherein:

the step of forming said wiring portion is a step of filling said groove with a conductor, which forms said wiring portion.

20. The substrate manufacturing method according to claim 14, wherein:

said wiring formation assistant layer is any one of a lift-off layer, a catalyst layer, a water-repellent layer, and an electroless plating assistant layer.

21. A method of manufacturing a flat panel display device comprising the step of forming the substrate ac-

**EP 1 651 018 A1**

cording to claim 13.

FIG. 1

FIG. 2

FIG. 3

FIG. 4

**FIG. 5**

EP 1 651 018 A1

FIG. 6

FIG. 7

<div align="center">**INTERNATIONAL SEARCH REPORT**</div>

| | International application No. |
|---|---|
| | PCT/JP2004/007880 |

| A. CLASSIFICATION OF SUBJECT MATTER |
|---|
| Int.Cl⁷ H05K3/10, G09F9/30 |

According to International Patent Classification (IPC) or to both national classification and IPC

| B. FIELDS SEARCHED |
|---|
| Minimum documentation searched (classification system followed by classification symbols) |
| Int.Cl⁷ H05K3/10, G09F9/30 |

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2004 |
| Kokai Jitsuyo Shinan Koho | 1971–2004 | Toroku Jitsuyo Shinan Koho | 1994–2004 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| Y | JP 10-209463 A (Matsushita Electric Industrial Co., Ltd.), 07 August, 1998 (07.08.98), (Family: none) | 1-7,10-21 |
| Y | JP 7-336017 A (Hitachi, Ltd.), 22 December, 1995 (22.12.95), Par. Nos. [0018], [0066] to [0076]; Fig. 5 (Family: none) | 1-7,10-21 |
| Y | JP 2001-188343 A (Nippon Zeon Co., Ltd.), 10 July, 2001 (10.07.01), (Family: none) | 6,17 |
| A | JP 2001-251039 A (Seiko Epson Corp.), 14 September, 2001 (14.09.01), (Family: none) | 1-21 |

☐ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 August, 2004 (10.08.04) | 24 August, 2004 (24.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)